# EUROPÄISCHE PATENTANMELDUNG

(11) **EP 4 114 159 A1**
(43) Veröffentlichungstag der Anmeldung: **04.01.2023**
(21) Anmeldenummer: 21182506.2
(22) Anmeldetag: 29.06.2021
(51) Int. Cl.: H05K 7/20, H01L 23/427, F28D 15/02

(54) **VORRICHTUNG ZUR WÄRMEABLEITUNG VON IN EINEM ELEKTRONIKGEHÄUSE ANGEORDNETEN MIKROELEKTRONISCHEN BAUTEILEN**

(71) Anmelder: Siemens Aktiengesellschaft, 80333 München (DE)
(72) Erfinder: Böhler, Sven, 91052 Erlangen (DE); Eder, Florian, 91054 Erlangen (DE); Pihale, Sven, 91792 Stopfenheim (DE)

(57) **Zusammenfassung**

Die Erfindung betrifft eine Vorrichtung zur Wärmeableitung von in einem Elektronikgehäuse angeordneten mikroelektronischen Bauteilen, insbesondere solchen, die auf einer Leiterplatte in einem Elektronikgehäuse angeordnet sind. Durch die Erfindung wird erstmals eine Vorrichtung zur Wärmeableitung von in einem Elektronikgehäuse angeordneten mikroelektronischen Bauteilen angegeben, die nicht ausschließlich auf primäre Wärmeableitung über eine Wärmeleitpaste setzt. Vielmehr ist vorgesehen, dass die Wärmeableitung über ein Arbeitsmedium, das im Elektronikgehäuse durch Verdampfen und Kondensieren Kühlleistung erbringt, erfolgt.

## Beschreibung

Die Erfindung betrifft eine Vorrichtung zur Wärmeableitung von in einem Elektronikgehäuse angeordneten mikroelektronischen Bauteilen, insbesondere solchen, die auf einer Leiterplatte in einem Elektronikgehäuse angeordnet sind.

Mikroelektronik als Schlüsseltechnologie stellt elektronische Bauteile in miniaturisierter Form auf einem Chip bereit, insbesondere integrierte Schaltkreise "ICs". Diese können Schaltungen mit vielen Milliarden elektronischen Bauelementen - insbesondere Dioden und/oder Transistoren - umfassen, so dass auch hochkomplexe Schaltungen wie Mikroprozessoren und Speicherchips auf wenige Quadratmillimeter kleinen Halbleiterplättchen untergebracht werden können. Die rechteckigen Halbleiterplättchen werden Chip genannt. Zunehmend können ganze Systeme wie Prozessoren, Schnittstellenschaltungen und Speicher auf einem einzelnen Chip realisiert werden. Diese werden in Reinsträumen hergestellt und sind sehr empfindlich. Zur Verwendung auf einer Leiterplatte wird der Chip in ein Gehäuse eingebaut.

Die stetige Miniaturisierung bei gleichzeitiger Leistungssteigerung erfordert immer effizientere Wärmeableitung bei diesen Chips. Dies stellt hohe Anforderungen an die Gehäuse, insbesondere auch die Packaging-Technologie. Beispielsweise für die fortschreitende vertikale Integration der einzelnen Bauteile in der Mikroelektronik sind die bisher bekannten Kühlkonzepte nicht leistungsfähig genug. Beispielsweise stellt eine Schicht Wärmeleitpaste oftmals ein Risiko für die dauerhafte Zuverlässigkeit dar, größere Kühlkörper wirken jedoch der geforderten Miniaturisierung entgegen.

Bisher wird zur Wärmeableitung in der modernen Leistungselektronik die primär von einer Wärmeleitpaste aufgenommene Abwärme der mikroelektronischen Bauelemente auf keramische Leiterplatten z.B. Rückseitenmetallisierung z.B. direct copper bonding "DCB" übertragen.

Dazu wird nach dem Einlegen des Chips in ein Elektronikgehäuse, beispielsweise in ein Kunststoffgehäuse, die Rückseite der DCB vergossen. Die Keramik, die als Abschirmung zusammen mit der Metallisierung - für die Wärmeableitung aus den Leistungselementen verantwortlich ist, leitet diese in eine Bodenplatte aus Metall weiter, die ihrerseits wieder an eine aktive Kühlung, beispielsweise über Lüfter und/oder Wasserkühlung, angeschlossen ist.

Aufgabe der vorliegenden Erfindung ist es daher, ein Kühlkonzept für miniaturisierte Mikroelektronik-Bauteile zur schaffen, das effizient leistungsstarke und miniaturisierte Bauteile kühlt, ohne dass die primäre Wärmeableitung der Bauelemente ganz oder maßgeblich über eine Wärmeleitpaste erfolgt.

Diese Aufgabe wird durch den Gegenstand der vorliegenden Erfindung, wie er in der Beschreibung, den Figuren und den Ansprüchen offenbart wird, gelöst.

Dementsprechend ist Gegenstand der Erfindung eine Vorrichtung zur Wärmeableitung von in einem Elektronikgehäuse angeordneten mikroelektronischen Bauelementen über die Verdampfungsenthalpie eines Arbeitsmediums, wobei die Vorrichtung in dem Elektronikgehäuse Mittel zum Transport des Kondensats des Arbeitsmediums von der kalten Stelle im Elektronikgehäuse zu den elektrische, optoelektrische und/oder elektronische Bauelementen hin umfasst.

Allgemeine Erkenntnis der Erfindung ist es, dass HalbleiterChips von integrierten Schaltungen, sowie Dioden, Transistoren, zur Abdichtung gegen Umwelteinflüsse, zur weiteren Verarbeitung, zum elektrischen Anschluss und zur Wärmeableitung Gehäuse brauchen, die so genannten Elektronikgehäuse. Davon gibt es bedrahtete Bauteile für die Durchsteckmontage "THT von Through Hole Technology" und Elektronikgehäuse für Oberflächenmontage "SMT" surface mounted technology oder "SMD" surface mounted device. Diese an sich bekannten Elektronikgehäuse lassen sich durch einfache Maßnahmen, wie Beschichtung an der Gehäuseinnenseite und Abdichtung in eine Vapor Chamber umbauen, die eine hocheffiziente Kühlung für die in der Kammer, der "Vapor Chamber" befindlichen miniaturisierten Bauteile des Chips bereitstellt.

Als "Elektronikgehäuse" wird vorliegend ein Gehäuse aus Kunststoff, Keramik, Verbundwerkstoff, und/oder Metall, respektive Metalllegierung bezeichnet. Das Elektronikgehäuse kann beliebige Kombinationen der vorbezeichneten Werkstoffe umfassen, es dient einerseits als Umhausung und/oder Träger für die elektrischen, optoelektrischen und/oder elektronischen Komponenten, insbesondere für Leiterplatten, Schalter, Kontakte, Durchführungen ggf. auch Bedienelemente, auf der anderen Seite dient es dem elektrischen /elektronischen Schutz der Bauelemente vor Belastungen der Umgebung und schließlich dient es dem Schutz des Nutzers vor den elektrischen, elektronischen und/oder optoelektrischen Bauelementen.

Bei der Verwendung eines Elektronikgehäuses als Vapor Chamber wird bevorzugt die Dichtigkeit des Elektronikgehäuses so ausgelegt, dass ein Unterdruck gehalten werden kann.

Als "Mittel zum Transport des Kondensats", wird vorliegend ein System, eine Oberfläche, Beschichtung, ein poröses Material innerhalb des Gehäuses, das im Zusammenspiel mit der Verdunstung des Arbeitsfluids durch die Abwärme der oder des Bauelements an einer vom Bauelement entfernten und kalten Stelle innerhalb des Elektronikgehäuses das Kondensat aufnimmt, transportiert und wieder zurück zum Bauelement lenkt. Dort umfasst das "Mittel zum Transport des Kondensats" Strukturen die durch die Abwärme des Bauelemente entsprechend warm sind und die Verdunstung ermöglichen.

Beispiele zu den Mittel zum Transport des Kondensats sind Beschichtungen mit Kanälen, Poren, offenen Poren, Fasern, Hohlfasern, Fasergelege, Schichten, Schäume, Lackschichten, poröse Strukturen, wie Matten. Bevorzugt sind die Oberflächen der Mittel eher dielektrisch als elektrisch leitend, wobei Polarität der Oberfläche an das Arbeitsfluid bevorzugt angepasst ist z.B. so, dass sie das Kondensat ansaugt.

Die Aufbringung der Mittel zum Transport des Kondensats erfolgt beispielsweise als aufgesprühte Beschichtung, lackierte Beschichtung, in Form einer auf metallischer Oberfläche erzeugten Struktur, beispielsweise mit zum Ansaugen des Kondensats geeigneter Polarisierung der Oberfläche. Die geeignete Oberflächenpolarisierung kann über eine Benetzungsmessung und/oder eine Messung des Kontaktwinkels erfolgen. #

Die Auswahl eines geeigneten Arbeitsmediums, auch als "Arbeitsfluid" bezeichnet, erfolgt nach verschiedenen Gesichtspunkten. Beispielsweise ist es essentiell, dass das Arbeitsmedium schwer entflammbar ist. Hinzu kommt, dass das Arbeitsfluid einen Siedepunkt im Temperaturbereich der Arbeitstemperatur von elektrischen, elektronischen und/oder optoelektrischen Bauelementen hat.

Das Arbeitsmedium darf nicht korrosiv sein, wobei es einen passenden Siedepunkt braucht, damit es durch die Abwärme der Bauelemente unter den Bedingungen der Vapor Chamber, also insbesondere bei Unterdruck von 0,5 bar oder weniger, verdampft und andererseits an einer kalten Stelle innerhalb der gleichen Vapor Chamber wieder kondensiert.

Bevorzugt ist das Arbeitsfluid dielektrisch oder elektrisch isolierend, damit es die einzelnen Bauelemente innerhalb des Elektronikgehäuses voneinander isoliert. Beispielsweise ist es vorteilhaft, wenn das Arbeitsfluid eine Dielektrizitätskonstante, höher als Luft, das genormt eine Dielektrizitätskonstante von 1 hat, hat.

Insbesondere als vorteilhaft hat sich der Einsatz von fluorierten Flüssigkeiten, insbesondere solchen, die Fluorether, beispielsweise Mono-, Di- oder höherwertige Fluorsubstituierte Ether, umfassen, in Tests als vorteilhaft erwiesen, weil diese wegen ihrer in der Regel hohen Dielektrizitätskonstante geeignet sind, die Spannungsabstände zwischen den elektrischen, elektronischen und/oder optoelektrischen Bauelemente innerhalb des Elektronikgehäuses zu erhöhen. Beispielsweise wurden Fluorether in Form des handelsüblichen 3M^{™} Novec^{™} - insbesondere das 3M^{™}Novec^{™} 7200 erfolgreich eingesetzt.

Andererseits konnten die unter der Bezeichnung "Galden HAT PFPE Heat Transfer Fluids" handelsüblichen Frostschutzmittel, insbesondere das "Galden HAT Low Boiling" der Kurt. J. Lesker Company erfolgreich eingesetzt werden.

Zur Klasse der Fluorether gehören beispielsweise Methylnonafluor-n-butylether, Methylnonafluor-iso-butylether, Ethylnonafluor-n-butylether, Ethylnonafluor-iso-butylether sowie beliebige Gemische dieser Fluorether untereinander und/oder mit anderen organischen Lösungsmitteln.

Auch die Klasse der Alkohole und auch reines destilliertes Wasser sind als Arbeitsmedium geeignet.

Weil die Oberflächenspannung der Flüssigkeit Einfluss auf die Sorptionseigenschaften - respektive die Kapillarkraft - des Mittels zum Transport des Kondensats hat, ist auch bevorzugt ein Mittel zum Transport des Kondensats einzusetzen, das eine geeignete und auf das Arbeitsmedium abgestimmte Oberflächenspannung hat.

Ein Wärmerohr, "Heat Pipe", ebenso wie eine "Vapor Chamber", die beide nach dem gleichen Prinzip funktionieren nur andere Form haben, sind Vorrichtungen zur Wärmeübertragung, die unter Nutzung von Verdampfungsenthalpie eines Arbeitsmediums eine hohe Wärmestromdichte erlauben. Auf diese Weise können große Wärmemengen auf kleiner Querschnittsfläche transportiert werden. Die Fähigkeit, Energie zu transportieren, hängt bei einem Wärmerohr maßgeblich von der spezifischen Verdampfungsenthalpie des Arbeitsmediums ab.

Weniger entscheidend sind sowohl die Wärmeleitfähigkeit des Arbeitsmediums als auch die Wärmeleitfähigkeit der Elektronikgehäusewand. Aus Effizienzgründen wird eine Vapor Chamber meist an der warmen Stelle, z.B. über oder unter dem Chip, nur knapp über dem und an der kalten Stelle, z.B. möglichst weit entfernt von der Wärmequelle, nur knapp unter der Siedetemperatur des Arbeitsmediums betrieben.

Eine Heat Pipe und/oder Vapor Chamber nutzen die Verdampfungsenthalpie und die Kondensationsenthalpie eines Arbeitsmediums aus, um hohe Wärmeströme zu bewegen. Die Hülle der Vapor Chamber wird häufig aus Kupfer, Messing, Bronze und/oder Aluminium oder entsprechenden Legierungen gefertigt. Das Arbeitsmedium im Inneren ist bevorzugt ein Kältemittel, wie z.B. Ammoniak, schwer entflammbare organisches Lösungsmittel, z.B. cycloaromatische organische Lösungsmittel, Fluoether, aprotische Lösungsmittel, Halogenwasserstoffe, wie z.B. das 1,1,1,2 - Tetrafluorethan, Kohlenstoffdioxid, Wasser, Kohlenwasserstoffe, Alkohole, sowie beliebige Gemische. Bevorzugt werden als Arbeitsmedium Fluide eingesetzt, die einen Siedepunkt zwischen 10°C und 200°C, insbesondere zwischen 40°C und 160°C und besonders bevorzugt zwischen 50°C und 140°C haben.

Die als Arbeitsfluid eingesetzten Kältemittel und/oder Frostschutzmittel haben vorzugsweise bei der Einstufung von Kältemittel die Einstufung nicht entflammbar (A1) und/oder schwer entflammbar (A2L). Beispielsweise werden diese Klassifizierungen nach der ASHRAE Klassifizierung durchgeführt. Dabei wird ein so genannter GWP-Wert festgestellt, der vorzugsweise bei den hier einsetzbaren Arbeitsfluiden bei einem Wert unter 170, vorzugsweise unter 150 und besonders bevorzugt unter 100 liegt.

Dieses verdampft - z.B. auch aufgrund eines Vakuums im Elektronikgehäuse - in der Vapor Chamber bereits bei sehr niedrigen Temperaturen. Nimmt die Vapor Chamber durch die Wärmequelle eine höhere Temperatur an, steigt der Druck. Wenn nun am anderen Ende der Vapor Chamber - z.B. durch externe Kühlung - eine niedrigere Temperatur entsteht, führt dies an dieser Stelle zu einer sogenannten Taupunktunterschreitung und damit zur Kondensation des Arbeitsmediums. Der Druck an dieser Stelle sinkt ab. Der Dampf in der Vapor Chamber strömt, dem Druckgefälle folgend, zur kälteren Stelle. Das Kondensat fließt durch Schwerkraft angetrieben und durch die Kapillarkräfte der Vapor Chamber zurück zum Ort des Verdampfens.

Aufgrund der gasförmigen und flüssigen Phase des Arbeitsmediums im Inneren der Vapor Chamber bildet sich ein übersättigter Dampf. Durch die geringen Druckunterschiede in der Vapor Chamber sind auch die Temperaturunterschiede und damit die sich einstellende Temperaturdifferenz zwischen Kondensator und Verdampfer nur gering. Eine Vapor Chamber besitzt daher einen sehr geringen Wärmewiderstand. Da der Wärmetransport indirekt über den stoffgebundenen Transport von latenter Wärme -Verdampfungs- oder Kondensationswärme - stattfindet, beschränkt sich der Einsatzbereich einer Vapor Chamber auf den Bereich zwischen der Schmelztemperatur und der Temperatur des kritischen Punktes des Arbeitsmediums. Für den Bereich von - 70 bis 60 °C kann beispielsweise Ammoniak als Arbeitsmedium eingesetzt werden. Die porösen Strukturen für den Rücktransport des Arbeitsmediums auch entgegen der Schwerkraft können durch eingelegte Kupferdrahtgeflechte (Mesh), durch Rillen (Grooves) und/oder durch gesinterte Kupferpartikel an der Innenfläche der Vapor Chamber erzielt werden. Je feiner diese Struktur ist, desto größer ist die Kapillarkraft.

Insbesondere die Form einer Vapor Chamber eignet sich zur Chip-Kühlung besser noch als eine Heat Pipe, weil die Wärme in einer Vapor Chamber nicht über ein Rohr abtransportiert wird, sondern schnell über eine große Fläche verteilt wird. So werden die Auswirkungen starker Hot Spots, wie sie auf dem Chip vorkommen, minimiert. Für die Vapor Chamber ist dabei nicht notwendigerweise eine poröse Innenwand zum Rücktransport des kondensierten Arbeitsmediums an den Ort des Hot Spots erforderlich, weil das z.B. einfach über die Schwerkraft funktioniert, wenn die Hot Spots unten in der Vapor Chamber liegen und der Dampf zur kühleren Decke aufsteigt, dort kondensiert und als Tropfen wieder nach unten fällt.

Nach einer vorteilhaften Ausführungsform der Erfindung wird ein Elektronikgehäuse komplett als Vapor Chamber hergestellt. Insbesondere vorteilhaft ist dabei, wenn das Vapor-Chamber-Elektronikgehäuse unabhängig von der Chipfertigung vorgefertigt wird.

Der Chip wird in respektive auf das Vapor- Chamber - Elektronikgehäuse montiert und kontaktiert.

Nach einer anderen Ausführungsform der Erfindung wird nur ein Teil des Elektronikgehäuses als Vapor Chamber ausgeführt.

Im Folgenden wird die Erfindung nun anhand einer Figur, die ein Ausführungsbeispiel der Erfindung schematisch wiedergibt, näher erläutert:

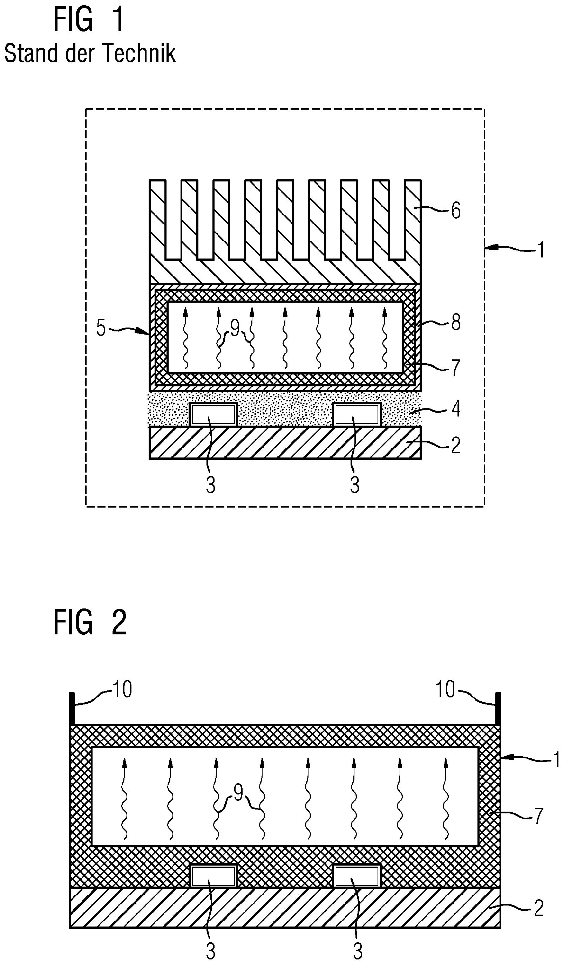

Figur 1 zeigt den Stand der Technik: Zu erkennen ist ein Elektronikgehäuse 1 in das Leiterplatte 2, Chip, respektive Bauelemente 3, die Wärmequellen 3 darstellen, und in eine Wärmeleitpaste 4 eingebettet sind. Eine Wärmeleitpaste enthält beispielsweise ein Silikonöl und/oder Polyethylenglykol und dient zur Wärmeübertragung zwischen zwei Objekten, also z.B. der Kühlfläche und/oder dem Elektronikgehäuse und einem Kühlkörper. Die Montageflächen von Kühlkörpern 6 und Bauelementen 3 enthalten stets mehr oder weniger tiefe Unebenheiten, die über Wärmeleitpasten 4 ausgeglichen werden.
   Die Wärmeleitpaste 4 schließt an eine Vapor Chamber 5 mit Kühlkörper 6 an. In der Vapor Chamber 5 ist die poröse Struktur an den Innenflächen 7 und ein Kupfergelege 8 erkennbar. In der Vapor Chamber 5 verdampft das Arbeitsmedium 9 von der wärmeren Seite unten nach oben hin an die kalte Stelle in der Vapor Chamber 5. Die - eine oder mehrere kalte(n) Stelle(n) in dem Vapor Chamber 5 sind die Stellen, an denen die Vapor Chamber aktiv über ein Kühlaggregat, wie hier einen Kühlkörper 6 gekühlt wird. Das Arbeitsmedium 9 verdampft also in Richtung kalte Stelle in der Vapor Chamber, wobei es abkühlt, kondensiert und durch die Schwerkraft getrieben und durch Mittel zum Transport des Kondensats gelenkt wieder nach unten fließt. Dort nimmt das Kondensat 9 wieder Wärme auf, verdampft und kondensiert an der kalten Stelle wieder ab.
   Der Engpass in der Wärmeableitung von den Bauelementen 3 nach dem hier in Figur 1 gezeigten Stand der Technik ist die Wärmeleitpaste 4, durch die nur in unzureichendem Maße Wärme zur Vapor Chamber 5 hin abtransportiert wird.
Figur 2 zeigt ein Schema eines Ausführungsbeispiels nach der Erfindung.

Zu erkennen ist wieder, wie in Figur 1, das Elektronikgehäuse 1, das bodenseitig mit der Leiterplatte 2 abschließt. Auf der Leiterplatte 2 und schon innerhalb der Vapor Chamber 5 befinden sich die Bauelemente und Wärmequellen 3. Diese sind gemäß der hier gezeigten beispielhaften Ausführungsform der Erfindung eingebettet in die poröse Struktur 7 an der Innenwand der Vapor Chamber 5. Die Vapor Chamber 5 hat oben noch Kontaktierungen 10. Das Prinzip ist wie beim Stand der Technik, nur wird anstelle der ineffizienten Wärmeableitung über die Wärmeleitpaste 4 und die Vapor Chamber 5 die erzeugte Wärme gleich in der Vapor Chamber 5 im Bereich des Kondensats 7, das entlang der porösen Struktur dem "Mittel zum Transport" in dem hier gezeigten Beispiel, nach unten fließt, abgegeben, so dass eine optimale Kühlung erfolgen kann.

Wie in Figur 2 gezeigt, wird das Elektronikgehäuse 1 durch wenige zusätzliche Schritte zu einer Vapor Chamber 5. Hierfür ist in einem ersten Schritt die Auftragung einer porösen Schicht zum Flüssigkeitstransport erforderlich. Auf die genaue Ausgestaltung wird in einem folgenden Abschnitt näher eingegangen.

In Figur 2 ist eine Ausführungsform gezeigt, bei der die Leiterplatte 2 den Boden des Elektronikgehäuses 1 bildet. Dies ist lediglich eine von vielen möglichen Anordnungen der Leiterplatte innerhalb des Elektronikgehäuses. Beispielsweise ist auch eine Anordnung denkbar, in der die Leiterplatte 2 innerhalb des Elektronikgehäuses oder innerhalb der porösen Struktur 7 sich befindet. Bei diesen Ausführungsformen ist der Vorteil, dass die Leiterplatte 2 beidseitig vom Arbeitsmedium der Vapor Chamber 5 umflossen wird.

In einem zweiten Schritt wird das Elektronikgehäuse mit dem Arbeitsmedium gefüllt, Unterdruck eingestellt und das Elektronikgehäuse abgedichtet. Bei der Wahl des Arbeitsmediums kann entsprechend der Auswahl bei herkömmlichen Heat Pipes vorgegangen werden.

Als Material für das Elektronikgehäuse kommen metallische Werkstoffe wie Aluminium oder Kupfer in Frage. Eine weitere interessante Bauweise stellt die Konstruktion des Elektronikgehäuses aus Faserverbundstoffen dar, hier könnte der Kapillareffekt auch durch offenliegende Fasern an der Innenwand des Gehäuses erzielt werden.

Da Compositmaterialien, also Verbundwerkstoffe, die zwei oder mehr verbundene Materialien umfassen, auf Faserbasis in der Regel keine isotropen Wärmeleiteigenschaften besitzen, werden zur Eignung als Struktur innerhalb einer Vapor Chamber durch gezielte Orientierung der Fasern entsprechende Vorzugsrichtungen erstellt, die dann als Mittel zum Transport des Kondensats eingesetzt werden können. Durch die Kombination aus Vapor Chamber 5 und Elektronikgehäuse 1 wird somit nicht nur ein bisher zugekauftes Bauteil eingespart und der Montageaufwand reduziert, es entsteht vor allem eine hochleistungsfähige Kühlkonstruktion, welche zudem wartungsfrei und ausfallsicherer ist als der Stand der Technik, der mit Wärmeleitpaste 4 arbeitet.

Die Nutzung des Elektronikgehäuses 1 als Vapor Chamber 5 ist vor allem mittels einer porösen Schicht innenseitig im Elektronikgehäuse zum Rücktransport der Flüssigkeit möglich. Diese wird auf die Innenseite des Gehäuses, des Deckels und auf die Leiterplatte und Bauteile aufgetragen, wie in Figur 2 gezeigt.

Durch die Art und Ausgestaltung dieser Schicht kann die Kühlleistung entscheidend beeinflusst werden, da häufig die Kapillarkraftgrenze und/oder die Wechselwirkungsgrenze die entscheidende Limitierung einer Vapor Chamber darstellt. Es kommen beispielsweise, aber nicht abschließend, die folgenden Materialien für eine poröse Beschichtung teilweise oder ganz auf der Innenfläche des Elektronikgehäuses in Frage:
- Zeolithische Partikel mit organischem Binder
- Offenporige Kunststoffschäume: Durch die Schäume an der Elektronikgehäusewand kann zusätzlicher mechanischer Schutz erzielt werden,
- Naturfasergewebe,
- Glasfasergewebe, insbesondere mit Klebeverbindung zur Wandung
- Pulverlacke, die so gehärtet werden, dass sie offenporig bleiben, z.B. über Platzhalter/ Templatebildner und/oder Treibmittel
- Aluminiumoxid-Oberflächen, die durch entsprechende Ätzprozesse auf normalem Aluminium hergestellt werden, beispielsweise so genanntes "flower-like alumina", das über den Precursor AlO(OH) durch Phasentransformation ein Aluminium mit Blüten ähnlicher Morphologie bezeichnet.

Um die Bauteile 3 vor dem Arbeitsmedium - z.B. zur Vermeidung von elektrischen Kurzschlüssen, Korrosion oder Explosion - zu schützen, ist es gemäß einer vorteilhaften Ausführungsform der Erfindung vorgesehen, dass eine "Schutzbeschichtung" auf der Elektronik aufgebracht wird, die vorzugsweise keinen nennenswerten zusätzlichen Wärmewiderstand bedeutet.

Mögliche Schutzbeschichtungen, falls ein Arbeitsfluid verwendet wird, welches eines der o.g. Probleme - Korrosion etc. - hervorrufen kann, sind beispielsweise:
- Eine Schutzbeschichtung, eine dünne Folie umfassend, beispielsweise herstellbar durch Auflaminieren einer dünnen Folie,
- eine Schutzbeschichtung, eine Plasmaschicht umfassend, und/oder
- eine Schutzbeschichtung einen wärmeleitfähigen Schutzlack umfassend.

Beispielsweise kann eine Ausführungsform der vorliegenden Erfindung durch das folgende schematische Aufbau- und Montagekonzept als eine "Elektronikgehäuseintegrierte Vapor Chamber" hergestellt werden:
- Die Leiterplatte 2 wird in ein Elektronikgehäuse 1 eingebracht
- Eine poröse Struktur 7 wird auf der Leiterplatte 2 mit den Bauelementen 3 und auf den Innenseiten des Elektronikgehäuses 1 teilweise oder ganz aufgetragen, dann
- Wird die Luft aus dem Elektronikgehäuseintegrierte Vapor Chamber 5 herausgepumpt und das Arbeitsmedium - das natürlich auch ein Gemisch verschiedener Arbeitsmedien sein kann - eingefüllt.

So entsteht eine hochwirksame, dauerstabile High-End-Kühllösung für Chip in einem Elektronikgehäuse ohne teure Materialien, ohne Zukaufteile und ohne großen Montageaufwand.

Erfindungsgemäß ist zusammenfassend vorgesehen, dass anstatt eines separaten Moduls, der "Vapor Chamber 5", welches auf die zu kühlende Oberfläche des Elektronikgehäuses 1 aufgebracht wird und das Arbeitsmedium enthält, das Arbeitsmedium der Vapor Chamber zur Kühlung direkt auf den Bauteilen, um die Bauteile herum und auf der Leiterplatte 2, wo gemäß Stand der Technik sich die Wärmeleitpaste 4 befindet, vorgesehen ist. Der Vorteil hierbei ist, dass der Transportschritt der Wärmeleitung durch die Wärmeleitpaste 4 und die Wand der Vapor Chamber 5 entfällt und das Arbeitsmedium so einen direkten Kontakt zu den Bauelementen 3, also zur Wärmequelle, hat.

Der thermische Widerstand wird durch die Erfindung also im Vergleich zu bisherigen Lösungen verringert. Durch den großen Durchmesser des Elektronikgehäuses im Vergleich zu den bisher erhältlichen Vapor Chambers sind auch deutlich größere Dampfund Flüssigkeitsströme möglich, die den Transport höherer Abwärmeströme ermöglichen. Durch die Kühlung der kompletten Leiterplatte 2 können keine Hot Spots entstehen, die den Bauteilen 3 schaden. Die Wärme wird durch die sofortige Verdampfung des Arbeitsmediums 9 verteilt und über das Nassdampfgebiet zum Kondensator transportiert. Durch die erfindungsgemäße Lösung wird die Anzahl der Wärmeübergänge auf das technisch absolut notwendige Minimum reduziert und ein maximal effizienter Wärmefluss gewährleistet, da nur Materialien zum Einsatz kommen, welche einen Kompromiss aus prinzipieller Anwendungstauglichkeit für Kühlapplikationen und fertigungstechnischer Verarbeitbarkeit darstellen.

Durch die Kondensation des Kühlmittels am Gehäusedeckel ist eine verbesserte Abführung der Wärme möglich, da eine wesentlich größere Oberfläche als bei den bisher verbauten Vapor Chamber Kühlern zur Verfügung steht. Die bisherige Konstruktion machte weiterhin eine Luftkühlung über einen Kühlkörper und Kühlrippen auf der Oberfläche der Vapor Chamber erforderlich um, um ausreichend Wärme abführen zu können. Durch die größere Oberfläche und eine direkte Anbindung an bspw. die Rahmenkonstruktion aus Metall kann die Wärme auch ohne diese zusätzlichen Elemente effizient abgeführt werden. Dies ermöglicht noch kompaktere Bauformen und weitere Miniaturisierungsmöglichkeiten.

Zudem kann durch eine beidseitige Beschichtung der Leiterplatte mit der porösen Schicht und einem entsprechenden Einbau im Gehäuse, erstmals eine beidseitige Kühlung einer Leiterplatte realisiert werden. Dieser könnte auch ein entscheidender Key-Enabler für neue Halbleitergenerationen mit erhöhten Schalt- und Leistungsdichten sein, da eine beidseitige Kühlung einen massiven Leistungssprung in der Wärmeabfuhrtechnik darstellt.

Durch die Auswahl und das Auftragen der porösen Schicht, können gezielt die Eigenschaften des Kühlsystems, z.B. die Arbeitfluidpumpmenge pro Zeit beeinflusst und die erforderliche Kühlleistung eingestellt werden.

In Vapor Chambers -"VCs" - und Heat Pipes -"HPs"- kommen im Hinblick auf die vorhandenen geometrischen Rahmenbedingungen technisch anspruchsvolle Materialstrukturen zum Einsatz. Es handelt sich um poröse Schichten auf der Innenseite von dünnen Metallrohren. Da HP generell keine allzu hohen Kosten verursachen dürfen, müssen die Prozesse und Verfahren, die zur Herstellung dieser Strukturen zum Einsatz kommen, so kostengünstig und damit einfach wie möglich gehalten werden. Die Folge ist, dass die Strukturen zwar prinzipiell ihre Funktion erfüllen, jedoch in keine Weise optimiert sind. Dies betrifft nicht nur das Porenvolumen, die Porosität oder die mittleren Porendurchmesser, sondern auch die Isolation des kühleren Medienrücktransports gegenüber der wärmeren Dampfphase.

Durch den Wegfall der geometrischen Begrenzungen können nun andere Materialien und Verfahren zur Erzeugung der Porosität zur Anwendung kommen, die neben deutlich vereinfachten Applikationsbedingungen eine örtlich besser aufgelöste Abscheidung der porösen Schicht und eine deutlich feinere Justage der Porositätseigenschaften z.B. die Schichtdicke, die bei der HP und der VC starkbegrenzt ist, Porenvolumina, ein mittlerer Kanaldurchmesser, die Benetzbarkeit -> diese beeinflusst am Ende die Fluidfördergeschwindigkeit und die gesamte Fördermenge.

Darüber hinaus bietet das erfindungsgemäße Konzept zusätzliche Tuning-Möglichkeiten über die Einstellung weiterer Oberflächeneigenschaften, die aufgrund der geometrischen Offenheit und Zugänglichkeit des Konzepts problemlos über übliche Beschichtungsverfahren erreicht werden können. Es handelt sich beispielsweise um die gezielte Einstellung der Benetzbarkeit unterschiedlicher Flächen. Während Verdampfungsflächen bevorzugt hydrophil ausgestaltet sein sollen (dies bedeutet eine verbesserte Benetzung, Vermeidung von Siedeverzügen und damit wieder besseren Wärmeübergang), sind Kondensationsflächen hydrophob auszugestalten. Die bewirkt ein Aufbrechen des Kondensatfilms und damit einen verbesserter Wärmeübergang an dieser Grenzfläche um einen Faktor bis zu 10.000.

Die Umwandlung des Gehäuses in eine gleichzeitige VC-Kühlung ermöglicht eine Hochleistungskühllösung mit geringen Kosten. Das Konzept einer gehäuseintegrierten VC bedingt, dass alle Bereiche gut zugänglich sind (keine engen Rohre). Somit können konventionelle Verfahren (Beschichtung, Montage, ...) verwendet werden. Das steigert die Produktqualität und senkt die Kosten. Da keine Wärmeleitpaste mehr benötigt wird, kann die Zuverlässigkeit weiter gesteigert werden.

Last but not least ergeben sich Vorteile bei Anwendungen, bei denen starke Vibrationen auftreten können. Hier ist eine klassische HP als Kühlkörper kritisch zu sehen, da die pseudo-geklebten Interfaces zum Teil versagen.

Beim Stand der Technik gelangt die abzuführende die Wärme aus dem elektronischen, optoelektrischen und/oder elektrischen Bauteil zunächst in die Wärmeleitpaste und dann über das Gehäuse in die Vapor Chamber und dort in das Arbeitsfluid. Bei der vorliegenden Erfindung gelangt die abzuführende Wärme direkt aus dem Chip in das Arbeitsfluid.

Durch die Erfindung wird erstmals eine Vorrichtung zur Wärmeableitung von in einem Elektronikgehäuse angeordneten mikroelektronischen Bauteilen angegeben, die nicht ausschließlich auf primäre Wärmeableitung über eine Wärmeleitpaste setzt. Vielmehr ist vorgesehen, dass die Wärmeableitung über ein Arbeitsmedium, das im Elektronikgehäuse durch Verdampfen und Kondensieren Kühlleistung erbringt, erfolgt.

## Patentansprüche

1. Vorrichtung zur Wärmeableitung von in einem Elektronikgehäuse (1) angeordneten mikroelektronischen Bauelementen (3) über die Verdampfungsenthalpie eines Arbeitsmediums (9), wobei die Vorrichtung in dem Elektronikgehäuse (1) Mittel (7,8) zum Transport des Kondensats des Arbeitsmediums (9) von der kalten Stelle im Elektronikgehäuse zu den mikroelektronischen Bauelementen (3) hin umfasst.

2. Vorrichtung nach Anspruch 1, bei der die mikroelektronischen Bauelemente (3) auf einer Leiterplatte (2) in dem Elektronikgehäuse (1) angeordnet sind.

3. Vorrichtung nach Anspruch 1 oder 2, bei der die Leiterplatte (2) Teil des Elektronikgehäuses (1) ist.

4. Vorrichtung nach einem der vorstehenden Ansprüche, bei der die Wand des Elektronikgehäuses zumindest zum Teil metallisch ist.

5. Vorrichtung nach einem der vorstehenden Ansprüche, bei der die Wand des Elektronikgehäuses zumindest zum Teil aus Faserverbundwerkstoff und/oder aus Kompositwerkstoff ist.

6. Vorrichtung nach einem der vorstehenden Ansprüche, bei dem das Arbeitsmedium ein Kältemittel ist, das einen Siedepunkt im Arbeitsbereich von Elektronik, also 10°C bis 200°C, hat.

7. Vorrichtung nach einem der vorstehenden Ansprüche, bei dem das Arbeitsmedium ein nicht entflammbares oder schwer entflammbares Kältemittel ist, das einen GWP-Wert kleiner 170 hat.

8. Vorrichtung nach einem der vorstehenden Ansprüche, bei dem das Arbeitsmedium ein Fluid ist, das einen Siedepunkt bei Normaldruck von 10°C bis 200°C hat.

9. Vorrichtung nach einem der vorstehenden Ansprüche, wobei auf der Innenseite des Gehäuses teilweise oder ganz ein Lack mit offenen Poren vorgesehen ist.

10. Vorrichtung nach einem der vorstehenden Ansprüche, wobei auf der Innenseite des Gehäuses teilweise oder ganz eine Belegung mit einem Fasergelege vorgesehen ist.

11. Vorrichtung nach einem der vorstehenden Ansprüche, wobei auf der Innenseite des Gehäuses teilweise oder ganz eine poröse Polymerfolie vorgesehen ist.

12. Vorrichtung nach einem der vorstehenden Ansprüche, wobei die in dem Elektronikgehäuse (1) angeordneten mikroelektronischen Bauelemente (3) mit einem Schutzbeschichtung überzogen sind.

13. Vorrichtung nach einem der vorstehenden Ansprüche, wobei Mittel zum Transport des Kondensats (7,8) offene Poren in Keramiken, Schäumen und/oder Kompositwerkstoffen umfassen.

14. Vorrichtung nach einem der vorstehenden Ansprüche, wobei Mittel zum Transport des Kondensats (7,8) Kanäle umfassen.

15. Vorrichtung nach einem der vorstehenden Ansprüche, wobei die Leiterplatte (2) Teil des Elektronikgehäuses (1) ist.
